# EUROPÄISCHE PATENTANMELDUNG

(11) **EP 4 665 102 A1**
(43) Veröffentlichungstag der Anmeldung: **17.12.2025**
(21) Anmeldenummer: 25181265.7
(22) Anmeldetag: 06.06.2025
(51) Int. Cl.: H05K 7/20, H02B 1/56

(54) **SCHRANK ZUR EINHAUSUNG ELEKTROTECHNISCHER KOMPONENTEN**

(30) Priorität: 15.06.2024 DE 102024116892
(71) Anmelder: Deutsche Bahn AG, 10785 Berlin (DE)
(72) Erfinder: Diebel, Ralf, 04509 Wiedemar (DE); Elsner, Dirk, 13187 Berlin (DE); Adolf, Björn, verstorben (DE)

(57) **Zusammenfassung**

Es wird ein Schrank (10) zur Einhausung elektrotechnischer Komponenten bereitgestellt, der ein einen Innenraum (12) umgebendes Gehäuse (11) umfasst. Das Gehäuse (11) ist an zumindest einer Seite des Schranks (10) doppelwandig mit einer Außenwand (24) und einer Innenwand (25) und einem zwischen der Außenwand (24) und der Innenwand (25) befindlichen Zwischenraum (26) ausgeführt. Erfindungsgemäß umfasst der Schrank (10) ein einen Hohlraum ausbildenden Sockelteil (14) mit Luftdurchlässen (21), wobei der Zwischenraum (26) luftleitend mit dem Hohlraum im Sockelteil (14) verbunden ist.

## Beschreibung

Die vorliegende Erfindung betrifft einen Schrank zur Einhausung elektrotechnischer Komponenten nach dem Oberbegriff des Anspruchs 1.

Schränke zur Einhausung elektrotechnischer Geräte, also Schaltschränke, oder auch Outdoorschränke, wie in der DE 102020122951A1 genannt, sind im Stand der Technik bekannt. Aus der EP 2561735 B1 geht beispielsweise ein in einem Funknetzwerkknoten eingeschlossener Schrank hervor. Wobei der Schrank einen ersten Satz elektronischer Ausrüstung und einen zweiten Satz elektronischer Ausrüstung, ein erstes Klimasystem und ein zweites Klimasystem umfasst, wobei das erste und zweite Klimasystem angeordnet sind, um Wärme von einem Innenvolumen zu einem Außenvolumen des Schranks zu übertragen, wobei das erste Klimasystem mit einer Heizvorrichtung versehen ist.

Die DE 29823425 U1 zeigt ein Schrankartiges Gehäuse, insbesondere für den Außeneinsatz, zur Aufnahme von Wärme erzeugenden, insbesondere elektrischen und/oder elektronischen, Baueinheiten. Bei dem Gehäuse ist ein Innenraum von Wänden umschlossen. Die Wände sind zumindest teilweise doppelwandig mit einer Außenwand und einer Innenwand und einem zwischen Außenwand und Innenwand angeordneten Zwischenraum ausgebildet, wobei die Innenwand aus dem Innenraum zumindest einen Teil der von den Baueinheiten erzeugten Wärme aufnimmt. Dabei sind erste Mittel vorhanden, welche zur Kühlung des Innenraums einen Luftstrom durch den Zwischenraum erzeugen. Das Gehäuse weist ein Dach auf, welches ein Zwischendach und ein über dem Zwischendach angeordnetes Oberdach umfasst, welches von dem Zwischendach beabstandet ist und seitlich unter Freilassung einer spaltförmigen Öffnung über das Zwischendach greift. Das Zwischendach greift über den nach oben offenen Zwischenraum der doppelwandigen Wand und schließt mit der zugehörigen Außenwand ab. Unterhalb des Zwischendaches und davon beabstandet sind zweite Mittel angeordnet, welche den Innenraum nach oben hin abschließen und seitlich an die Innenwand der doppelwandigen Wand anschließen.

Die CN 204669769 U zeigt ein Gestell, das einen Gestellkörper und eine mobile Vorrichtung umfasst, wobei der Gestellkörper Seitenwände, obere und untere Platten und eine Innentrennwand einschließt. Der Innenraum des Gestellkörpers ist durch die Innentrennwand in einen Lagerteil und einen Belüftungsteil unterteilt, wobei der Lagerteil zur Lagerung von Computerausrüstung dient. Die Seitenwände sind geschlossene Flächenwände es sind und Öffnungen auf der oberen Platte und der unteren Platte vorhanden sind. Der Belüftungsteil ist mit einem Belüftungsventilator ausgestattet, der mit der Öffnung auf der oberen Platte verbunden ist. Die Seitenwände sind in vollständig geschlossener Form ausgeführt und es ist sowohl oben als auch unten eine Öffnung vorhanden.

Der Erfindung liegt die Aufgabe zugrunde, einen bezüglich der Klimatisierung verbesserten derartigen Schrank bereitzustellen.

Gelöst wird diese Aufgabe mit einem Schrank nach Anspruch 1. Vorteilhafte Weiterbildungen der Erfindung sind in den Unteransprüchen angegeben.

Der erfindungsgemäße Schrank zur Einhausung elektrotechnischer Komponenten mit einem einen Innenraum umgebenden Gehäuse. Das Gehäuse ist an zumindest einer Seite des Schranks doppelwandig mit einer Außenwand und einer Innenwand und einem zwischen der Außenwand und der Innenwand befindlichen Zwischenraum ausgeführt. Erfindungsgemäß umfasst der Schrank ein einen Hohlraum ausbildenden Sockelteil mit Luftdurchlässen, wobei der Zwischenraum luftleitend mit dem Hohlraum im Sockelteil verbunden ist.

Damit ist vorteilhaft ein Schrank mit verbesserter thermischer Isolation gegenüber der Umgebung des Schranks bereitgestellt. Mit dem Sockelteil ist die Gesamthöhe des Schranks nach unten erweitert, was die Luftströmungsverhältnisse im Schrank vorteilhaft beeinflusst.

In einer vorteilhaften Ausgestaltung des erfindungsgemäßen Schranks ist der Zwischenraum hermetisch mit der Umgebung des Schranks verbunden.

Damit ist der Zwischenraum belüftet und kann zur Wärmeabfuhr, also zur Kühlung des Innenraums des Schranks beitragen.

In einer weiteren vorteilhaften Ausgestaltung des erfindungsgemäßen Schranks sind in dem Zwischenraum vertikale Rippen angeordnet. Die Rippen sind bevorzugt symmetrisch ausgeführt.

Die Rippen vergrößern die Oberfläche der Innenwand, wodurch diese mehr Wärme abgeben kann. Zudem sind mit den Rippen viele kleine Luftkanäle ausgebildet, in denen die durchströmende Luft gerichtet nach oben geleitet wird. Der Luftstrom kühlt die Innenwand dadurch effektiver.

In einer weiteren vorteilhaften Ausgestaltung des erfindungsgemäßen Schranks umfasst dieser ein Dachteil mit Luftdurchlässen.

Mit dem Dachteil ist die Gesamthöhe des Schranks nach oben erweitert, was ebenfalls die Luftströmungsverhältnisse im Schrank vorteilhaft beeinflusst.

Der Schrank ist damit vorteilhaft dazu geeignet, allein mittels Abwärme der elektrotechnischen Komponenten einen Luftstrom in der Weise des Kamineffekts zu erzeugen. Zusätzlich bietet das Dachteil Raum für die optionale Anordnung eines Lüfters. Der Lüfter kann den Luftstrom und die damit bewirkte Wärmeabfuhr verstärken. Insbesondere ist in dem Dachteil zudem ein Luftfilter angeordnet.

In einer weiteren vorteilhaften Ausgestaltung des erfindungsgemäßen Schranks ist in dem Innenraum ein Transformator in einem oberen Bereich des Schranks angeordnet, wobei der obere Bereich oberhalb eines unteren Bereichs angeordnet ist und der untere Bereich mindestens doppelt so hoch ist wie der obere Bereich. Insbesondere ist in dem Innenraum im unteren Bereich Schalttechnik angeordnet.

Der Transformator ist also im oberen Drittel des Schranks angeordnet. Damit ist eine Anordnung bereitgestellt, die die Temperaturverteilung im Innenraum während des Betriebs des Transformators vorteilhaft beeinflusst. Die Zone unterhalb des Transformators wird wesentlich weniger erwärmt als die Zone oberhalb des Transformators. Durch die geringeren Temperaturmaximalwerte in der Zone unterhalb des Transformators können die klimatischen Anforderungen an dort angeordnete Bauelemente, insbesondere an die Schalttechnik, geringer ausfallen beziehungsweise wird deren Verwendung dort erst ermöglicht. Die Schalttechnik ist durch die Anordnung unterhalb des Transformators zudem sehr gut zugänglich.

Weitere Vorteile der vorliegenden Erfindung sind aus der detaillierten Beschreibung und den Abbildungen ersichtlich. Die Erfindung wird anhand der Abbildungen und der nachfolgenden Beschreibung näher erläutert. Es zeigen:
Fig.1 einen erfindungsgemäßen Schrank zur Einhausung von elektrotechnischen Komponenten in einer bevorzugten Ausgestaltung; und
Fig. 2 eine Prinzipskizze des erfindungsgemäßen Schrankes.

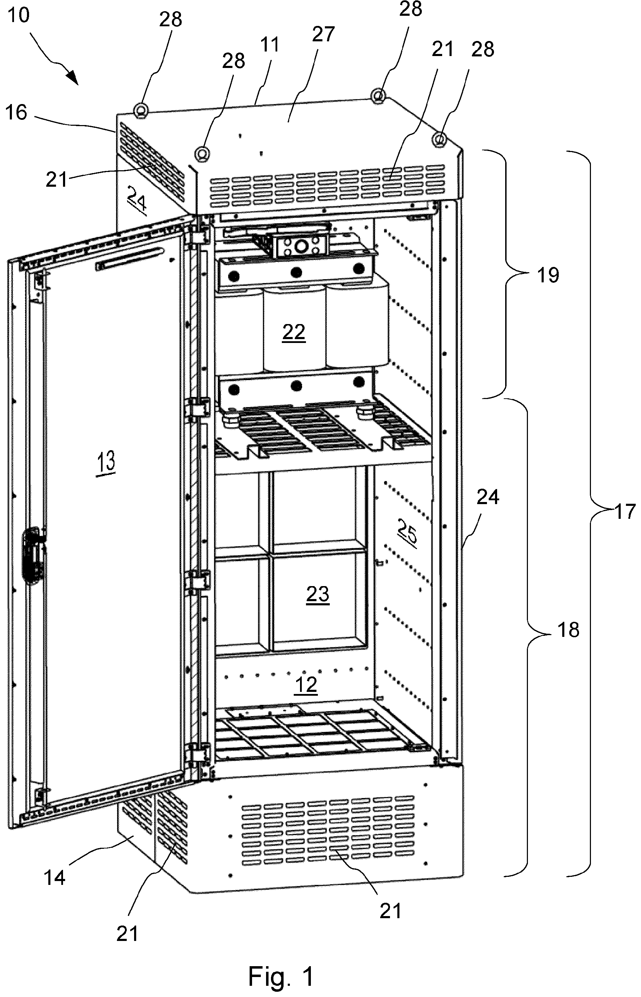

In der Fig. 1 ist der erfindungsgemäße Schrank 10 zur Einhausung von elektrotechnischen Komponenten in einer beispielhaften Ausgestaltung schematisch dargestellt.

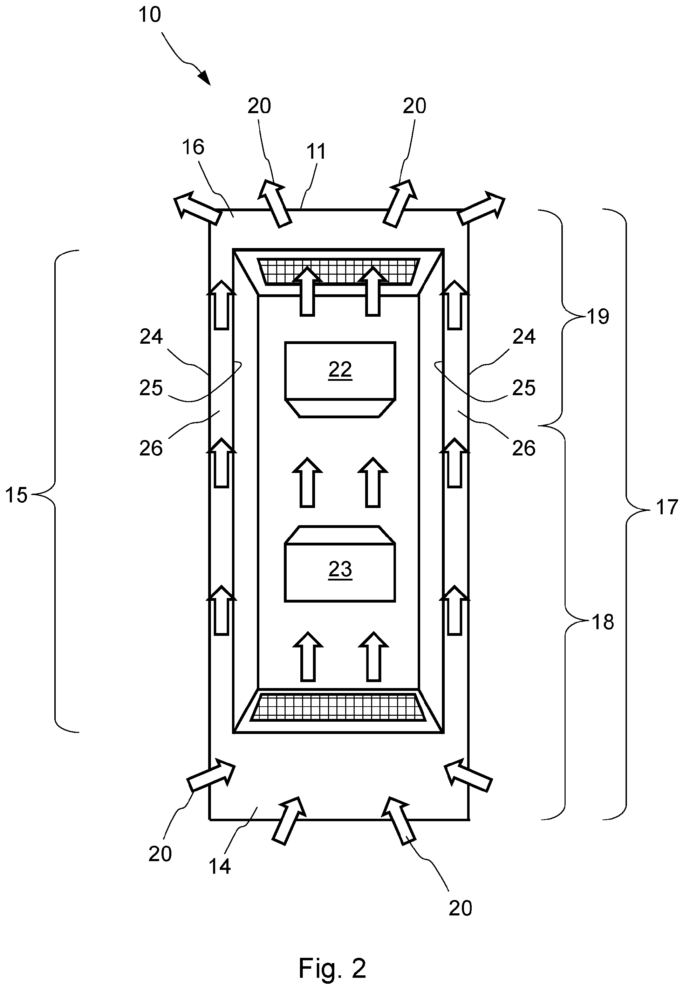

Der Schrank 10 umfasst ein Gehäuse 11, welches einen Innenraum 12 umgibt. Erfindungsgemäß ist das Gehäuse 11 zumindest an einer Seite des Schranks 10 doppelwandig ausgeführt. Das ist in der Figur 2 gezeigt, in der der Schrank 10 zur besseren Veranschaulichung seiner Wirkungsweise in einer Schnittdarstellung skizziert ist. Insbesondere sind beide Seitenwände und die Rückwand des Gehäuses 11 doppelwandig ausgebildet. Der Schrank 10 umfasst bevorzugt eine Tür 13, die den Zugang zum Innenraum 12 in üblicher Weise freigibt beziehungsweise verschließt. In der Figur 1 steht die Tür 13 des Schranks 10 offen. Auch die Tür 13 ist bevorzugt doppelwandig ausgebildet. Mithin sind bevorzugt die vier vertikalen Seiten des Schranks 10 doppelwandig ausgeführt. Bei der doppelwandigen Ausführung sind jeweils eine Außenwand 24 und eine Innenwand 25 beabstandet zueinander angeordnet, wobei zwischen der Außenwand 24 und der Innenwand 25 ein Zwischenraum 26 gebildet ist.

Der Schrank 10 ist zur Aufnahme elektrotechnischer Bauelemente im Innenraum 12 ausgelegt, insbesondere zur Aufnahme eines Transformators 22 und zur Aufnahme von Schalttechnik 23. In dieser Weise ist es in den Figuren 1 und 2 dargestellt. Der Transformator 22 ist dabei als ein Abwärme erzeugendes Bauteil bevorzugt in einem oberen Bereich 19 des Schranks 10 angeordnet. Der Transformator 22 ist bevorzugt auf einer luftdurchlässigen Ebene, insbesondere auf einem Gitter und/oder einer Konsole angeordnet. Der obere Bereich 19 ist das obere Drittel des Schranks 10. Der obere Bereich 19 ist oberhalb eines unteren Bereichs 18 angeordnet und der untere Bereich 18 ist mindestens doppelt so hoch wie der obere Bereich 19. Der obere Bereich 19 grenzt an den unteren Bereich 18. Der untere Bereich 18 und der obere Bereich 19 bilden zusammen eine Gesamthöhe 17 des Schranks 10. Die Gesamthöhe 17 des Schranks 10 resultiert also aus der Summe der Höhe des unteren Bereichs 18 und der Höhe des oberen Bereichs 19. Die Schalttechnik 23 ist bevorzugt im unteren Bereich 18 angeordnet.

Bevorzugt umfasst der Schrank 10 ein Sockelteil 14, das unterhalb der Tür 13 beziehungsweise einer Türöffnung angeordnet ist. Das Sockelteil 14 ist im Wesentlichen hohl. Das Sockelteil 14 bildet also einen Hohlraum aus. Zudem umfasst der Schrank 10 insbesondere ein Dachteil 16, das oberhalb der Tür 13 beziehungsweise der Türöffnung angeordnet ist. Auch das Dachteil 16 ist im Wesentlichen hohl. Der Innenraum 12 und bevorzugt auch der zumindest eine Zwischenraum 26 sind hermetisch mit der Umgebung des Schranks 10 verbunden. Dazu weist der Schrank 10 mehrere Luftdurchlässe 21 auf. Die Luftdurchlässe 21 können als Gitter und/oder Schlitze und/oder Kiemen oder dergleichen ausgebildet sein. Insbesondere im Sockelteil 14 und im Dachteil 16 verfügt der Schrank 10 über Luftdurchlässe 21. Der Schrank 10 weist die Luftdurchlässe 21 bevorzugt oberhalb und unterhalb der Position des Transformators 22 auf, nicht aber an der Position des Transformators 22. So verfügt der Schrank 10 über einen Abschnitt 15, in dem keine Luftdurchlässe 21, die Luft vom Innenraum 12 nach außen und von außen in den Innenraum 12 durchlassen, angeordnet sind. Der zumindest eine Zwischenraum 26 ist erfindungsgemäß luftleitend mit dem Hohlraum im Sockelteil 14 verbunden. Insbesondere ist der zumindest eine Zwischenraum 26 mit dem Hohlraum im Dachteil 16 verbunden. So ist der zumindest eine Zwischenraum 26 auch ohne eigenen Luftdurchlass 21 hermetisch mit der Umgebung des Schranks 10 verbunden.

Der Schrank 10 ist dazu ausgebildet, mittels der Abwärme der im Innenraum 12 angeordneten elektrotechnischen Komponenten, bevorzugt mittels der Abwärme des Transformators 22 einen Kamineffekt zu erzeugen. Der Abschnitt 15 weist die dafür erforderliche Höhe auf. Durch im Betrieb des Transformators 22 erzeugte Wärme wird im Innenraum 12 des Schranks 10 und in dem zumindest einen Zwischenraum 26 jeweils ein nach oben gerichteter Luftstrom 20 erzeugt. Der zumindest eine Luftstrom 20 ist in der Figur 2 durch Pfeile dargestellt. Durch diesen Luftstrom 20 wird Luft im unteren Bereich 18, insbesondere am Sockelteil 14, von außen aus der Umgebung nach innen in den Innenraum 12 und den zumindest einen Zwischenraum 26 gesogen. Die angesogene Luft durchströmt den Innenraum 12 im Wesentlichen vertikal nach oben und umströmt dabei die elektrotechnischen Bauelemente, wodurch diese weitere Wärme an die Luft abgeben und so gekühlt werden. Zudem durchströmt die angesogene Luft den zumindest einen Zwischenraum 26 im Wesentlichen vertikal nach oben und nimmt dabei Wärme von der Innenwand 25 auf, wodurch auch diese gekühlt wird. Im oberen Bereich 19, insbesondere im Dachteil 16 strömt die erwärmte Luft aus dem Schrank 10 wieder nach außen. Der Innenraum 12 und der zumindest eine Zwischenraum 26 sind luftleitend mit dem Dachteil 16 verbunden. Insbesondere ist in dem Dachteil 16 ein nicht dargestellter Lüfter angeordnet. Der Luftstrom 20 kann durch den Betrieb des Lüfters verstärkt werden.

In dem zumindest einen Zwischenraum 26 sind bevorzugt nicht dargestellte, vertikal verlaufende Rippen angeordnet. Bevorzugt verlaufen die Rippen parallel zueinander. Mit den Rippen ist die Oberfläche der Innenwand 25 vergrößert. Zudem sind mit den Rippen mehrere kleine vertikale Kanäle gebildet, in denen die Luft gerichtet nach oben strömen kann. Zudem umfasst der Schrank 10 insbesondere vertikale Rippen im oberen Bereich 19 an einer zum Innenraum 12 gerichteten Oberfläche der Innenwand 25.

Der Schrank 10 weist bevorzugt ein schräges Dach 27 auf, von dem Niederschlag gut abgleiten kann. Das Dach 27 ist zudem bevorzugt mit vier Transportösen 28 versehen. Der Schrank 10 umfasst insbesondere ein nicht dargestelltes Adaptergitter, welches an einem nach Süden gerichteten Luftdurchlass 21 angebracht ist und sich beim Erwärmen durch Sonneneinstrahlung positiv auf das Strömungsverhalten auswirkt, da es die durchströmende Luft beschleunigt. Der Schrank 10 ist in der Weise ausgebildet, dass sich im Betrieb der elektrotechnischen Komponenten die wärmste Zone knapp unterhalb des Daches 27 ausbildet. Von dort ist der Weg zur Ableitung nach außen sehr kurz und sehr schnell.

### Bezugszeichenliste:

- 10: Schrank
- 11: Gehäuse
- 12: Innenraum
- 13: Tür
- 14: Sockelteil
- 15: Abschnitt
- 16: Dachteil
- 17: Gesamthöhe
- 18: Unterer Bereich
- 19: Oberer Bereich
- 20: Luftstrom
- 21: Luftdurchlass
- 22: Transformator
- 23: Schalttechnik
- 24: Außenwand
- 25: Innenwand
- 26: Zwischenraum
- 27: Dach
- 28: Transportöse

## Patentansprüche

1. Schrank (10) zur Einhausung elektrotechnischer Komponenten mit einem einen Innenraum (12) umgebenden Gehäuse (11), wobei das Gehäuse (11) an zumindest einer Seite des Schranks (10) doppelwandig mit einer Außenwand (24) und einer Innenwand (25) und einem zwischen der Außenwand (24) und der Innenwand (25) befindlichen Zwischenraum (26) ausgeführt ist, **dadurch gekennzeichnet, dass** der Schrank (10) ein einen Hohlraum ausbildenden Sockelteil (14) mit Luftdurchlässen (21) umfasst, wobei der Zwischenraum (26) luftleitend mit dem Hohlraum im Sockelteil (14) verbunden ist.

2. Schrank (10) nach Anspruch 1, **dadurch gekennzeichnet, dass** der Zwischenraum (26) hermetisch mit der Umgebung des Schranks (10) verbunden ist.

3. Schrank (10) nach einem der vorhergehenden Ansprüche, **dadurch gekennzeichnet, dass** in dem Zwischenraum (26) vertikale Rippen angeordnet sind.

4. Schrank (10) nach einem der vorhergehenden Ansprüche, **dadurch gekennzeichnet, dass** der Schrank (10) ein Dachteil (16) mit Luftdurchlässen (21) umfasst.

5. Schrank (10) nach Anspruch 4, **dadurch gekennzeichnet, dass** in dem Dachteil (16) ein Lüfter angeordnet ist.

6. Schrank (10) nach einem der vorhergehenden Ansprüche, **dadurch gekennzeichnet, dass** in dem Innenraum (12) ein Transformator (22) in einem oberen Bereich (19) des Schranks (10) angeordnet ist, wobei der obere Bereich (19) oberhalb eines unteren Bereichs (18) angeordnet ist und der untere Bereich (18) mindestens doppelt so hoch ist wie der obere Bereich (19).
